**Europäisches Patentamt**

**European Patent Office**

**Office européen des brevets**

(19)

(11)     **EP 1 633 051 A1**

(12)     **EUROPEAN PATENT APPLICATION**

(43) Date of publication:
**08.03.2006 Bulletin 2006/10**

(51) Int Cl.:
*H03M 3/02* (2006.01)

(21) Application number: **04405553.1**

(22) Date of filing: **06.09.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(71) Applicant: **Berner Fachhochschule Hochschule für Technic und Architektur Biel**
**2501 Bienne (CH)**

(72) Inventors:
• **Jacomet, Marcel**
**2543 Lengnau (CH)**

• **Müller, Lorenz**
**2505 Biel (CH)**
• **Cattin-Liebl, Roger**
**2540 Grenchen (CH)**
• **Götte, Josef**
**2543 Lengnau (CH)**

(74) Representative: **Liebetanz, Michael et al**
**Isler & Pedrazzini AG,**
**Patentanwälte,**
**Postfach 6940**
**8023 Zürich (CH)**

(54)     **Sigma-Delta modulator and Sigma-Delta A/D converter**

(57)     A digital only $\Sigma\Delta$ modulator comprises a node (14) which can be connected to a current source (12), representing the analog input signal, a quantizer element and a sample-and-hold element (10) mounted in series having an input (11) and an output (17), wherein said input (11) is connected to said node (14) and said output (17) representing the digital output signal, a resistor element (18) being connected between the output (17) of the sample-and-hold element (10) and said input (11) of the quantizer element (10), and a capacitance (16) connected to said node (14).

Fig. 2

EP 1 633 051 A1

**Description**

The invention relates to a $\Sigma\Delta$ modulator and a $\Sigma\Delta$ A/D converter.

Technical Background of the invention

The emergence of powerful digital signal processing in $C_{MOS}$ $V_{LSI}$ technology creates the need for high-resolution A/D converters that can be integrated in fabrication technologies optimized for digital circuits and systems. However, the same scaling of VLSI technology that makes possible the continuing and dramatic improvements in digital signal processing also severely constraints the dynamic range available for implementing the interfaces between the analog and the digital representation of signals. Oversampled AD converters based on $\Sigma\Delta$ modulation use sampling frequencies well above the Nyquist rate in order to exchange resolution in time for resolution in amplitude.

The $\Sigma\Delta$ conversion technique exists since many years. Technological advances make the technique practical and their use widespread. The converters are used in applications such as communication systems, consumer and professional audio, industrial weight scales, and precision measurement devices. The key feature of the $\Sigma\Delta$ converters is that they are the only low-cost conversion method which provides both high dynamic range and flexibility in converting low-bandwidth input signals (see Steven R. Norsworthy, Richard Schreier and Gabor C. Temes in "Delta-Sigma Data Converters" from John Wiley & Sons, 1997.

The performance of digital signal processing systems is generally limited by the precision of the digital input signal which is achieved at the interface between the analog and the digital signal representation. $\Sigma\Delta$ modulation based A/D conversion technology is a cost effective approach for high-resolution converters which can ultimately be integrated on digital signal-processor ASICs. Known $\Sigma\Delta$ converters employ $\Sigma\Delta$ modulators built with active analog components. Such analog integrated circuits have high design costs. The resulting oversampling A/D converters then achieve a relatively high resolution with more than 12 bits and Nyquist rates above 50 kHz, and the development trends are towards even higher Nyquist rates.

However, the development costs of these components makes integration of $\Sigma\Delta$ converters less interesting for application areas, as for certain sensor-signal A/D conversions, where lower resolutions and lower Nyquist rates are sufficient.

Summary of the invention

It is therefore an object of the invention to provide a $\Sigma\Delta$ modulator, which can be directly integrated, e.g. on digital signal-processor ASICs.

It is a further object of the invention to provide a $\Sigma\Delta$ modulator, which does not use any active analog components to reduce integration costs.

It is another object of the invention to provide a $\Sigma\Delta$ modulator, which can be implemented in a software driven control unit.

It is a further object of the invention to provide a $\Sigma\Delta$ converter having the advantages of use of the $\Sigma\Delta$ modulators according to the invention.

Therefore, a new architecture for a first-order $\Sigma\Delta$ modulator is proposed, that uses as the only analog components a resistor and a capacitor to realize the (lossy) analog integrator-part of the modulator. Because there is no need for active analog components to realize the $\Sigma\Delta$ modulator, it is possible in implementing the "digital-only" $\Sigma\Delta$ A/D converter directly in an FPGA (Field Programmable Gate Array). Alternatively, it is possible to implement the approach in the software of a microprocessor.

The "digital-only" implementation of the proposed $\Sigma\Delta$ A/D converter greatly enhances compatibility: Any digital FPGA or microprocessor can be programmed to implement the necessary $\Sigma\Delta$-based A/D conversion directly on chip or in software, respectively, without using any additional active analog components. An important advantage then is that new applications can be designed with the high assurance of a first-right implementation, as digital circuit designs provide, thus eliminating the higher design risks of mixed analog-digital designs.

Although the new architecture has limited resolution due to theoretical limitations imposed by the used lossy integrator, there is a broad range of application areas, mainly in sensor-data analog-to-digital conversion. It is to be noted that the simplicity of the approach outweighs resolutions limited to something in the range of 8 to 10 bits and Nyquist rates considerably lower than that of conventional $\Sigma\Delta$ A/D converters.

Brief description of the drawings

A solution for said object of the invention is achieved with a device with the features of claim 1.

Further objects and advantages are achieved through the features of the subclaims. Exemplary embodiments of the invention are disclosed in the following description in which:

Fig. 1   shows a schematic of a $\Sigma\Delta$ modulator according to prior art,
Fig. 2   shows a schematic of a $\Sigma\Delta$ modulator according to a first embodiment of the invention,
Fig. 3   shows a schematic of a $\Sigma\Delta$ modulator according to a second embodiment of the invention,
Fig. 4   shows a schematic of a $\Sigma\Delta$ converter according to the invention,
Fig. 5   a graphic representation of a simulated devil's stair-case,
Fig. 6   shows a block diagram of the test environment for over-sampled AD converters,
Fig. 7   a graphic representation of a devil's staircase obtained in hardware tests, and
Fig. 8   shows a test input signal $y_0[n]$ (dashed) and demodulated output signal $y[n]$ (solid).

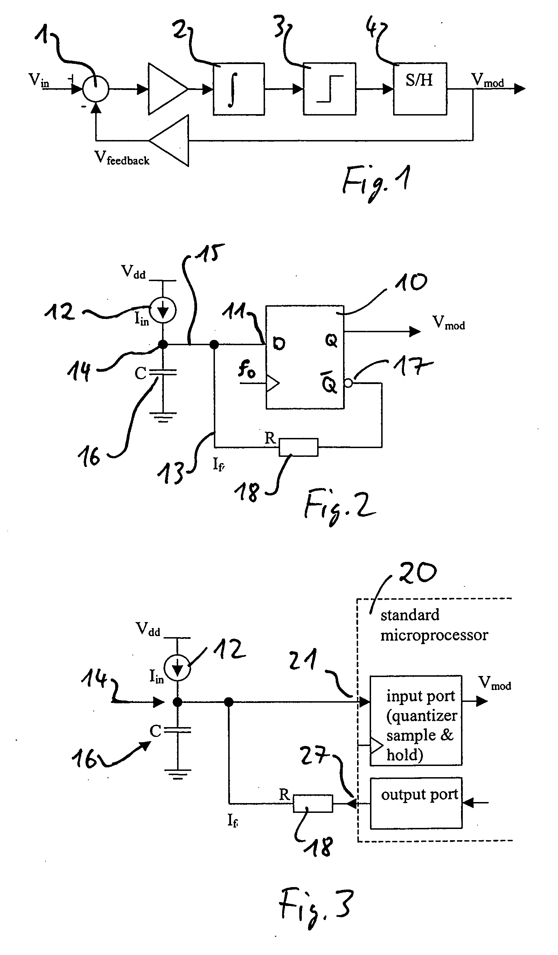

Fig. 1 shows a $\Sigma\Delta$ modulator according to prior art. A voltage $V_{in}$ is added to a feedback voltage $V_{feedback}$ at the adder 1. The resulting summed voltage signal is integrated in integrator 2, passes a quantizer 3 and a sample & hold circuit 4 to provide the digital signal $V_{mod}$.
Fig. 2 shows a schematic of a modulator according to a first embodiment of the invention. The D-flip-flop 10 (DFF) represents a threshold input/output port of the involved FPGA or the microprocessor, respectively. The DFF is clocked by the oversampling frequency $f_0$ and processes an analog input 11 according to formula (1) :

$$q(v_c(nT_0)) = \begin{cases} V_{dd} & if \ v_c(nT_0) < V_{dd}/2, \\ 0 & if \ v_c(nT_0) \geq V_{dd}/2, \end{cases}$$

where $T_0$ is the oversampling interval, $T_0 = 1/f_0$. Note that this DFF 10 acts as quantizer in the $\Sigma\Delta$ converter and that it prepares the negative feedback by a sign change. The D-flip-flop 10 combines the function of an quantizer and a sample & hold unit.
The current source $i_s$, reference numeral 12, represents the analog input signal to be converted to digital form. In the shown main application this current signal comes from a photo-diode, but any sensor whose output signal is a current, or can be converted to a current, can be interfaced by the circuit to a digital hardware.
The input current signal $i_s$, 12 and the feedback current signal if (with logically negative sign), reference numeral 13, are summed in node 14. It is assumed that there is no current flow into the DFF to input 11. This is equivalent to the assumption that $i_f$ flows in line portion 15 to node 11. The capacitance C, reference numeral 16, acts as an integrator for the total current and outputs the voltage signal $v_c$, which is the input to the clocked quantizer-block DFF. Inverted output 17 of the DFF 10 is connected via the resistor R having the numeral 18 to line 13 and therefore to node 14.
The operation of the circuit in Fig. 2 can be modeled for left-open right-closed time intervals $(nT_0,(n+1)T_0]$ by formula (2)

$$\dot{v}_c = \left(-\frac{1}{RC}\right)v_c + \frac{1}{RC}\left(q(v_c[n]) + v_s\right)$$

where we have defined the equivalent input voltage $v_s$ by $v_s \triangleq R \cdot i_s$, and where $v_c[n]$ is the capacitor voltage at the end of the previous interval $((n-1)T_0, nT_0]$, $v_c[n] \triangleq v_c(nT_0)$.
To obtain a circuit description in the form used by other authors, it is useful to transform the state variable $v_c(t)$ in formula (2) into a new state variable u(t) according to

$$u(t) \triangleq 1 - \frac{2}{V_{dd}} \cdot v_c(t)$$

In this new state the circuit is described by formula (3)

$$\dot{u} = \left(-\frac{1}{RC}\right) \cdot u + \frac{1}{RC}\left(x - \mathrm{sgn}(u[n])\right) ,$$

where sgn($\cdot$) denotes the signum function, and the new input $x(t)$ is related to $v_s(t)$ by $x \triangleq 1/(V_{dd}/2) \cdot v_s$. The output of the transformed circuit is sgn($u[n]$) and is a sequence of numbers "+1" and "-1" which may by symbolically represented by "bits" 1 (+1) and 0 (-1) . The output of the proposed circuit, $q(v_c[n])$, is a sequence of numbers $V_{dd}$ and 0 and is related to the output of the transformed circuit by $q(v_c[n]) = (\mathrm{sgn}(u[n])+1)) \cdot V_{dd}/2$.

Because we are only interested into the output sequence sgn(u[n]) and the sequence of states at the end of the left-open time intervals $(nT_0,(n+1)T_0]$, $u(t=(n+1)T_0)u[n+1]$, we solve formula (3) for these time intervals $(nT_0,(n+1)T_0]$ and evaluate at $t=(n+1)T_0$. Superimposing the free response due to initial conditions $u(nT_0{}^+) \triangleq u[n]$ being the final state of the previous interval $((n-1)T_0,nT_0]$ (superscript "+" indicating that the argument $nT_0{}^+$ belongs to the left-open interval $(nT_0, (n+1)T_0]$), and the forced response due to the input $x(t)$-sgn($u[n]$), $t \in (nT_0, (n+1T_0]$, it is obtained, after evaluating at $t=(n+1)T_0$, the following first-order difference equation formula (4):

$$u[n+1] = p\, u[n] + (1-p)(x[n+1] - \mathrm{sgn}(u[n])) ,$$

where $g \triangleq 1 - p$. Here the feedback gain $p$ is given in terms of the parameters of the circuit, R and C, and the oversampling interval $T_0$ by $p \triangleq \exp\{-T_0/(RC)\}$, and the input gain g is, as indicated, related to $p$ by $g=1-p$.

The input x[n+1] in formula (4) is related to the true input x(t) in the differential equation (3) as follows: If x(t) is a piecewise constant signal, that is, it is a constant inside the intervals $(nT_0,(n+1)T_0]$, $x[n+1]$ denotes these constant values and the description formula (4) is an exact discrete equivalent of formula (3). If x(t) is not a piecewise constant signal, it may be assumed in practice that it is slowly time-varying with respect to the oversampling-interval duration $T_0$ and that it is bounded. From the mean-value theorem of the integral calculus it is known then that x[n+1] is a sample of x(t) at some time instant $\zeta \in (nT_0,(n+1)T_0]$. Likewise we may interpret $x[n+1]$ as an average value of $x(t)$ in $(nT_0, (n+1)T_0]$ (the RC combination in the circuit filters the signal x(t)).

We note that the difference equation (4) is the single-loop lossy $\Sigma\Delta$ system analyzed by other authors such as Orla Feely and leon O. Chua in "The effect of integrator leak in Sigma-Delta modulation" in IEEE Trans. Circuits Syst., 38(11):1293-1305, November 1991. Compared to the sigma-delta modulator analyzed in said reference, this modulator has the additional constraints:

$$p = \exp\left\{-\frac{T_0}{RC}\right\}, \quad g = 1 - p$$

that is, the loss $p$ of the discrete-time equivalent modulator in equation (4) is given by the design of the analog realization - the time constant RC - and by the selected oversampling frequency $f_0=1/T_0$; and the input gain g of the discrete-time equivalent modulator in (4) is fixed once the feedback gain $p$ is selected. Intuitively, it is clear that designing a feedback gain $p$ as close to 1 as possible is preferable, because $p$ approaching 1 means approaching the ideal non-lossy integrator situation; however, it can be seen that in the limit $p \rightarrow 1$ the input gain g to the (for $p=1$ ideal) accumulator becomes zero, killing the approach.

We next discuss some basic theoretical limitations of the lossy $\Sigma\Delta$ modulator circuit, that is, we discuss the effects of $p<1$, $g=1-p$.

Feely and Chua discuss in their paper as mentioned above the lossy sigma-delta modulator (4) for DC input signals: For modulators with ideal integrator and constant input, the output of the system (when averaged over a "long enough" time period) equals the input; for integrators with leak, however, they show that the plot of input versus average-output is no longer linear but has a fractal "staircase" structure, the devil's staircase. Therefore, the resolution of the modulator is limited by the width and the displacement of these steps.

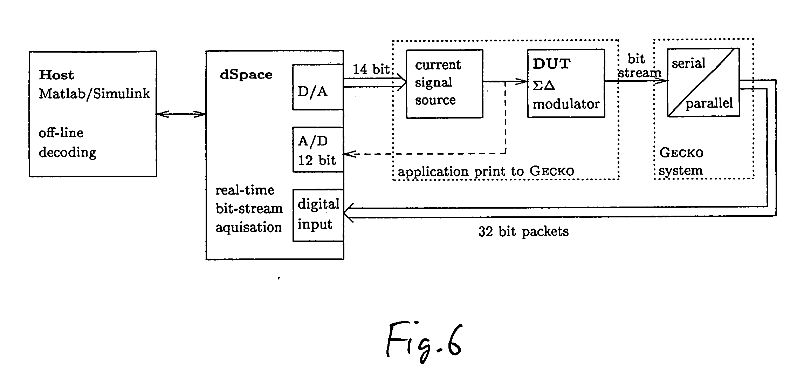

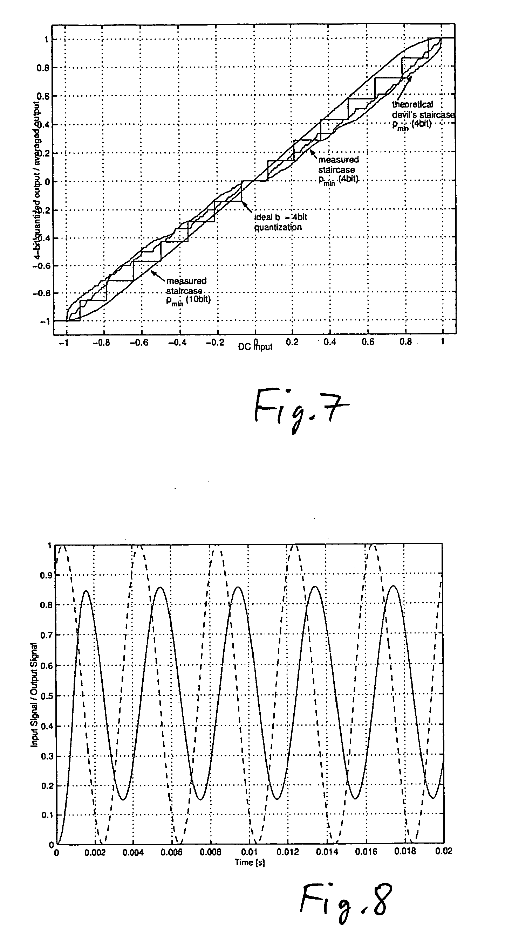

Figures 7 and 8 in said paper show the devil's staircase of the constant-input $x$ to average-output map of a lossy sigma-delta modulator with $p=0.8$ for $-1 \leq x \leq 1$. We have reproduced such a devil's staircase by the curve "devil's staircase" in Fig. 5 together with the characteristics of a "uniform quantization" of the interval $-1 \leq x \leq 1$ with $b=4$ bits. Note that this low 4 bit resolution is used to make clearly visible the characteristics of the resulting staircase; as shown below, the circuit according to the invention achieves a much higher resolution. It can be seen that the widest step of the devil's staircase appears in the vicinity of zero inputs. The reference Feely and Chua gives for the width of this widest step a value of $2(1-p)/(1+p)$.

If the final goal of our complete sigma-delta converter is to obtain a uniform quantization of the interval $-1 \leq x \leq 1$ with b bits, as Fig. 5 shows for $b=4$ bits, we argue that the widest step-width must be smaller than the aimed-at resolution. Formula (5)

$$p > \frac{2^b - 3}{2^b - 1} \triangleq p_{\min}$$

is obtained for lower limits of the allowable loss $p$. Table 1 shows the minimally needed loss values that are, in the best case, necessary to achieve a uniform quantization with b bits; "best case" means that we use an averaging of the sigma-delta modulator output bit-stream over a "long enough" time period, that is, that we use a sufficiently powerful decoding in the subsequent digital processing stage.

Table 1:

| b | 4 | 5 | 6 | 7 | 8 | 9 | 10 |
|---|---|---|---|---|---|---|---|
| $p_{min}$ | 0.8667 | 0.9355 | 0.9683 | 0.9843 | 0.9922 | 0.9961 | 0.9981 |

In the example shown in Fig. 5 the mentioned displacements of the steps in the devil's staircase with respect to the "ideal $y=x$" characteristic is seen. We argue that the errors introduced by these displacements can be removed by employing a pre-warping in the decoder. So the displacements of the steps from the "ideal $y=x$" positions are the lesser problem, but no decoder can remove the errors due to non-zero step widths in the devil's staircase (the sigma-delta modulator according to the invention) is just not able to distinguish inputs lying in intervals of same height of the devil's staircase. The accompanying loss of resolution is a non-linear function of the input, and the greatest loss of resolution occurs in the neighborhood of the rational numbers with lowest denominators, see also the discussion in Feely and Chua.

As far we have not yet discussed the influence of the non-unity gain g of the sigma-delta modulator. Feely and Chua note that a non-unity gain g has only an influence on how quickly the modulator's output sgn(u[n]) enters periodicity: sgn($u[n]$) latches onto its periodic cycle as soon as the state $u[n]$ enters the region $[g(x-1)\ g(x+1))$. For the $\Sigma\Delta$ modulator with $g=1-p$ we now argue as follows: If we like to obtain a better resolution, we must realize a larger $p$ according to Table 2. Such a larger $p$ consequently gives a smaller $g=1-p$, and the latching interval $[g(x-1),\ g(x+1))$ becomes smaller. Therefore, we expect that it takes more $\Sigma\Delta$ modulator clock cycles for sgn(u[n])-the $\Sigma\Delta$ modulator output bit-stream-to enter periodicity.

To find the number of sigma-delta modulator clock cycles needed for $u[n]$ to enter into the interval $[g(x-1),g(x+1))$, we have programmed an exhaustive search over possible DC input values x[n+1]=const=x and initial conditions $u[0]$, determining the maximum number of clock cycles needed to enter said interval. In the rectangle $(-1\leq x\leq1) \times (-1\leq u[0] \leq1)$ we find for $p=p_{min}$ and $g=1-p$ the results compiled in Table 2.

Table 2

| b | 4 | 5 | 6 | 7 | 8 | 9 | 10 |
|---|---|---|---|---|---|---|---|
| max # | 10 | 31 | 86 | 218 | 528 | 1237 | 2834 |

Although we have done experiments with various resolutions of the rectangle $(-1\leq x\leq1)\times(-1\leq u[0]\leq1)$, and we have always obtained the values given in Table 2, these experiments are of course no proof for correctness. Nevertheless, we are convinced that the obtained figures for the number of clock cycles needed for sgn($u[n]$) to enter periodicity are, at least, good indications.

An idea to reduce the maximum number of clock cycles needed to enter the latching interval is to use "dither noise:" We add to the Dc input value to be converted random numbers, $x\rightarrow x+w[n]$ with $w[n]$ a low-variance noise sequence, and hope that the bit sequence sgn(u[n]) sooner enters periodicity. A consecutive question then is whether sgn ($u[n]$) stays, in the presence of noise, on its periodic cycle. We have found, however, that "dither noise" does not help; on the contrary, it increases the maximum number of needed clock cycles, with larger noise levels leading to stronger increases.

To verify that the arguments above are correct for the analog-digital circuit in Fig. 2, we have performed simulations with MATLAB/SIMULINK.

Concerning the minimally needed loss-values $p_{min}$ for a target resolution, we find by our mixed-signal simulations that our circuit indeed achieves the expected resolutions. As an example, the curve "simulated staircase" in Fig. 5 shows the obtained staircase for $p = p_{min}$ (4bits) = 0.8667, $g$=1-$p$. Simulations for bits $b \in \{5,6,7,8,9,10\}$ with values of $P_{min}$ according to Table 2 yield corresponding results. As the steps in the respective staircases become very small and are hardly visible, we do not present here the respective graphs.

Fig. 5 shows uniform quantization for $b$=4 bits, devil's staircase obtained as average output of a single-loop lossy sigma-delta modulator with $p$=0.8 and $g$=1, and the staircase obtained by simulating the mixed analog-digital circuit for $p=p_{min}(4bits)$=0.8667, $g$=1-$p$.

Concerning the latching onto limit cycles, our simulations of the analog-digital circuit in Fig. 2 re-obtain the worst-case values given in Table 2. Unfortunately, these worst-case values are quite high: For a ten bit resolution, for instance, they suggest that we would have to wait 2834 clock cycles before we could start with the averaging in the decoding procedure. These worst-case arguments are, however, only valid if we operate our $\Sigma\Delta$ modulator with a sample-and-hold running at the Nyquist rate. When we sample a signal with a sample-and-hold running at Nyquist rate, then the sampled sequence of Dc values are independent of each other and, therefore, of the initial conditions, because the initial conditions are the final conditions of the last operation interval Operating the $\Sigma\Delta$ modulator without a sample-and-hold unit does not produce the worst-case situation.

Furthermore, these worst-case values are not realistic in the case of time-varying input signals. Therefore, we have simulated an exhaustive search over possible Dc input values $x[n+1]$=constx and initial conditions u[0] to determine the number of clock cycles needed to enter periodicity. There is a wide valley with a low number of needed clock cycles to enter periodicity. This observation clearly indicates that the worst case figures are not too relevant for time-varying signals to be converted. To underpin this claim, we have performed mixed-signal simulations with a sinusoidal input-signal applied to our $\Sigma\Delta$ modulator, and have traced the sequences of input values and initial conditions. These two sequences then define a locus in the plane "DC input/initial condition". The simulation results indicate that for time-varying input signals the needed number of clock cycles to enter periodicity is in fact very low: It is true that the notion "needed number of clock cycles to enter periodicity" is not well defined for time-varying input signals as it is for Dc input signals. We here cross-compare only to gain an idea of what happens in the much more complicated situation of time varying inputs. For our sinusoidal input-signal simulations we have seen that said path stays, after an initial downhill movement due to intentionally used worst-case initial conditions for the complete simulation, always in the bottom of the valley of the landscape.

Fig. 6 shows a block diagram of the test environment for oversampled AD converters: The $\Sigma\Delta$ modulators are operated in real-time, and the deconding procedures run off-line.

To test and to characterize $\Sigma\Delta$ modulators built according to the invention in hardware, we have built a test environment for oversampling AD converters. Fig. 6 shows its block diagram. Whereas this test environment lets the modulator part of oversampling converters run in real time, associated decoding algorithms may be tested and characterized by an off-line post-processing on a host computer. This off-line decoding facility allows easy experimentation with alternative decoding procedures proposed in the literature, but applies to bit-streams from modulators running in real time on true analog hardware components. The $\Sigma\Delta$ modulator according to Figure 2 runs, as mentioned, in real time and is driven by a test current-signal source. This current source is controlled by a software running on a real-time DSPACE system (see "Real-time development system, autobox with ds1103 board, 2004, dspace.com), allowing to freely generate signal forms of the analog current-signal to be converted. The bit stream of the $\Sigma\Delta$ modulator under test is clocked into a GECKO system (see Marcel Jacomet et al. "On a development environment for real-time information processing in systems-on-chip solutions" in IEEE 14th Symposium on Integrated Circuit and System Design, SBCCI'04, Brazil. 10-15 September 1991), where it is converted to 32bit wide packets that are in turn read-back to the DSPACE system. Presently, the DSPACE systems runs at clock frequencies of up to 70kHz, and the $\Sigma\Delta$ modulator can run at 500kHz. $\Sigma\Delta$ modulator bit-streams collected on the DSPACE system can be read-back to the host computer for later off-line processing, but the host computer can program the DSPACE software for test-signal generation as well.

First measurements on our test environment concern Dc input signals; they confirm our theoretical and simulation results. The curve measured staircase for $p_{min}$(4bits) in Fig. 7 very well compares to the curve theoretical devil's staircase $p_{min}$ (4bits). For comparison we also supply the curve measured staircase $p_{min}$(10bits). Fig. 7 shows uniform quantization for $b$=4 bits, devil's staircase obtained for $p_{min}$ (4bits), measured staircase for $p_{min}$ (4bits), and measured staircase for $p_{min}$ (10bits).

Concerning the dynamic performance of the novel $\Sigma\Delta$ modulator, we have setup an overall experiment-including the decoding stage-as follows: On the MATLAB level we generate a sinusoidal signal $y_0 [n]$ with frequency $f_{sin}$ and sampling frequency $f_0$=500kHz. A resampled version of this signal $y_0[n]$ is sent to the digital-to-analog converter of the DSPACE system running at a sampling frequency of 70 kHz . This DSPACE output signal controls our current-source generating the input signal for the $\Sigma\Delta$ modulator under test. The $\Sigma\Delta$ modulator is clocked with 500kHz to generate its bit stream. Our test-environment reads the generated bit-stream and passes it to the off-line decoding stage realized in MATLAB. Here we presently only use a $sinc^2$ filter. The resulting sample sequence $y[n]$ is next compared to the original signal $y_0[n]$, see Fig. 8. Note that we have not yet applied a $sinc^2$ corretion to the output signal $y[n]$, which exlains the reduced amplitude of the output signal as well as its shift in time in Figure .

For a numerical comparison we compute the error sequence $y_D[n] \doteq y_0[n] - y[n]$, and in turn its power $P_\Delta$, to finally obtain the signal-to-error ratio $10\log_{10}(P_0/P_\Delta)$, where $P_0$ is the power of the original signal $y_0[n]$. We have carried-out the discussed power computations in the frequency domain. We find a signal-to-error ratio of approximately 45dB. Computing the signal-to-error ratio with respect to an ideal reference signal means that we assume an ideal output signal from the DSPACE analog output. Since the DSPACE digital-to-analog converter has 14 bits resolution, the output signal is not an ideal sinusoid. The error due to this non-ideality is, by the present experiment, attributed to our $\Sigma\Delta$ converter. Furthermore, non-idealities of the current source in our test environment likewise introduce errors that are attributed to our $\Sigma\Delta$ converter. To attribute all the errors due to the test environment to the device under test is incorrect. Therefore, the obtained results are worst-case-results for our $\Sigma\Delta$ converter. First guesses indicate that our test environment adds about 6dB to the signal-to-error ratio, leading to the conclusion that the obtained measurements correspond to a resolution of the expected 8bits. The described experiment has been repeated for various input signal frequencies $f_{sin}$, yielding results of comparable performance.

Fig. 8 shows a test input signal $y_0[n]$ (dashed) and demodulated output signal $y[n]$ (solid) for a sinusoidal frequency $f_{sin}=250$ Hz with a $sinc^2$ decoding filter of length $L=2\cdot256$, and $\Sigma\Delta$ modulator parameter $p=0.9922$.

We have proposed a novel architecture for a first-order $\Sigma\Delta$ modulator that needs no active analog components. We have shown here that for Dc and sinusoidal input signals our approach achieves resolutions of more than 8bits. We have obtained our measurement results on a versatile test environment for oversampling converters. With the presented "digital-only" $\Sigma\Delta$ modulator we implement AD converters in FPGA's and in the software of microprocessors: We have realized our novel "digital-only" $\Sigma\Delta$ modulator in AD converters used in a prototype of an e-commerce product. This application involves an optical data-channel with four photo-diode receivers. Four oversampling $A_D$ converters based on our new "digital-only" $\Sigma\Delta$ modulator run concurrently on one ARM7TDMI microprocessor. Each AD converter has a resolution of 7 bits and a Nyquist rate of 1kHz.

Fig. 3 shows an alternative embodiment of the modulator according to the invention. Same features have received same numerals. The node 14 is connected to an input 21 of a standard microprocessor 20, having an output 27, connected to the resistor 18 as in Fig. 2. This enables the software implementation of the quantization and sample-and-hold process as well as generating the inverted output signal with software instructions within the micro processor 20.

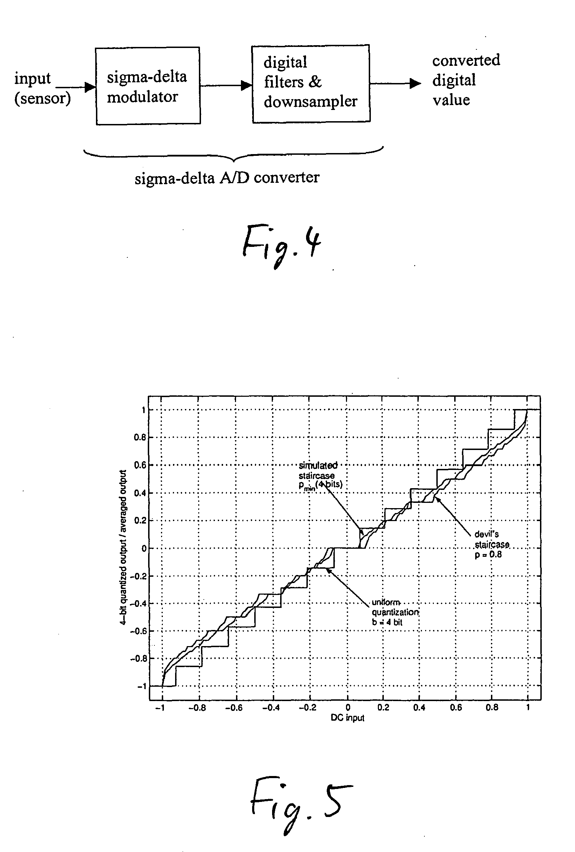

Fig. 4 shows a schematic of a $\Sigma\Delta$ converter according to the invention, comprising a sigma-delta modulator as shown in Fig. 2 or 3 and digital filters and downsamplers. This enables the conversion of an input signal, e.g. from a photo-diode or another current source, to a digital output signal, using only digital components and no active analog components.

**Claims**

1. $\Sigma\Delta$ modulator comprising:

   - a node which can be connected to a current source, representing the analog input signal,
   - a quantizer element and a sample-and-hold element mounted in series having an input and an output, wherein said input is connected to said node and said output representing the digital output signal,
   - a resistor element being connected between the output of the sample-and-hold element and said input of the quantizer element, and
   - a capacitance connected to said node.

2. $\Sigma\Delta$ modulator according to claim 1, wherein the quantizer element and the sample-and-hold element are a flip-flop, wherein the digital signal is output at one output whereas the resistor element is connected to an inverted output.

3. $\Sigma\Delta$ modulator according to claim 2, wherein the flip-flop is a DFF and the output signal of the flip-flop is either the voltage over the current source and the capacitance if the voltage over the capacitance is lower than said voltage divided by two, or said output signal is 0, if the voltage over the capacitance is greater or equal to said voltage divided by two.

4. $\Sigma\Delta$ modulator according to one of claims 1 to 3, wherein the capacitance is connected to earth.

5. $\Sigma\Delta$ modulator according to one of claims 1 to 4, wherein the current source is a sensor or wherein the current source is a voltage which can be converted to a current.

6. $\Sigma\Delta$ modulator according to one of claims 1 to 5, wherein the quantizer element and the sample-and-hold element are provided within an integrated circuit and wherein the node is connected directly to an input port of said integrated circuit and is connected via the resistor element with an output port of said integrated circuit.

7. $\Sigma\Delta$ modulator according to claim 6, wherein said integrated circuit is a microprocessor.

8. $\Sigma\Delta$ modulator according to claim 7, wherein the function of the quantizer element and the function of the sample-and-hold element are realized through program instructions within the microprocessor.

9. $\Sigma\Delta$ modulator according to one of claims 1 to 8, wherein said current source is a sensor element, especially a photo diode.

10. $\Sigma\Delta$ A/D converter comprising:

   - a $\Sigma\Delta$ modulator according to one of claims 1 to 9, and
   - at least one digital filter and/or downsampler.

11. $\Sigma\Delta$ A/D converter comprising integrated elements of the $\Sigma\Delta$ modulator according to one of claims 1 to 9, and at least one digital filter and/or downsampler.

Fig.1

Fig.2

Fig.3

*Fig. 4*

*Fig. 5*

Fig. 6

Fig. 7

Fig. 8

**European Patent Office**

**EUROPEAN SEARCH REPORT**

Application Number

EP 04 40 5553

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | GB 2 292 028 A (* HEWLETT-PACKARD COMPANY) 7 February 1996 (1996-02-07) | 1,4-6, 9-11 | H03M3/02 |
| Y | * figure 2a; page 1, lines 14-15, page 2, lines 3-23, page 6, lines 5-15 * | 2,3,7,8 | |
| Y | KINNIMENT D J: "PSEUDOANALOGUE OPERATION IN DIGITAL CIRCUITS" IEE PROCEEDINGS G. ELECTRONIC CIRCUITS & SYSTEMS, INSTITUTION OF ELECTRICAL ENGINEERS. STEVENAGE, GB, vol. 136, no. 3, 1 June 1989 (1989-06-01), pages 150-154, XP000098159 ISSN: 0622-0039 * page 150, section 2, first paragraph; figure 1 * | 2,3 | |
| Y | WO 90/12459 A (DIGITAL APPLIANCE CONTROLS, INC) 18 October 1990 (1990-10-18) * figure 1 * | 7,8 | |

TECHNICAL FIELDS SEARCHED (Int.Cl.7)

H03M

The present search report has been drawn up for all claims

| Place of search | Date of completion of the search | Examiner |
|---|---|---|
| The Hague | 11 February 2005 | Beindorff, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 1 633 051 A1

## ANNEX TO THE EUROPEAN SEARCH REPORT
## ON EUROPEAN PATENT APPLICATION NO.

EP 04 40 5553

This annex lists the patent family members relating to the patent documents cited in the above-mentioned European search report.
The members are as contained in the European Patent Office EDP file on
The European Patent Office is in no way liable for these particulars which are merely given for the purpose of information.

11-02-2005

| Patent document cited in search report | | Publication date | Patent family member(s) | | Publication date |
|---|---|---|---|---|---|
| GB 2292028 | A | 07-02-1996 | DE | 19518508 A1 | 08-02-1996 |
| | | | JP | 8065166 A | 08-03-1996 |
| WO 9012459 | A | 18-10-1990 | WO | 9012459 A1 | 18-10-1990 |

EPO FORM P0459

For more details about this annex : see Official Journal of the European Patent Office, No. 12/82

14